(19) Europäisches Patentamt
European Patent Office
Office européen des brevets

(11) **EP 2 698 919 A1**

(12) **EUROPEAN PATENT APPLICATION**

(43) Date of publication:
**19.02.2014 Bulletin 2014/08**

(51) Int Cl.:
***H03J 3/20*** (2006.01)

(21) Application number: **12180373.8**

(22) Date of filing: **14.08.2012**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**

(71) Applicant: **Sequans Communications
Winnersh Triangle
Reading
Berkshire RG41 5RB (GB)**

(72) Inventor: **Martin, Peter
Reading, Berkshire RG41 5RB (GB)**

(74) Representative: **Neobard, William John
Kilburn & Strode LLP
20 Red Lion Street
London WC1R 4PJ (GB)**

(54) **Integrated circuit**

(57)    An integrated circuit device has an LC tank circuit for frequency determination, and a switched capacitor circuit for tuning the resonant frequency of the LC tank.

The switched capacitor circuit has plural sets of parallel branches, each set comprising a first branch and a second branch, the first and second branches each connecting between a first node and a second node, each branch containing a respective capacitor in series with a switch, the switched capacitor circuit being configured such that, in use, the switch of the first branch is on when the switch of the second branch is off and vice versa

Fig 4

**Description**

The present invention is in the general field of integrated circuits, and more specifically but not exclusively to the field of frequency tuning in integrated circuits.

For many years oscillators in which the frequency is dependent on LC resonance have been known. Although it would be possible to vary or control the frequency of such an oscillator by varying the inductance of the resonant circuit, this is not convenient where the circuitry forming the oscillator is integrated.

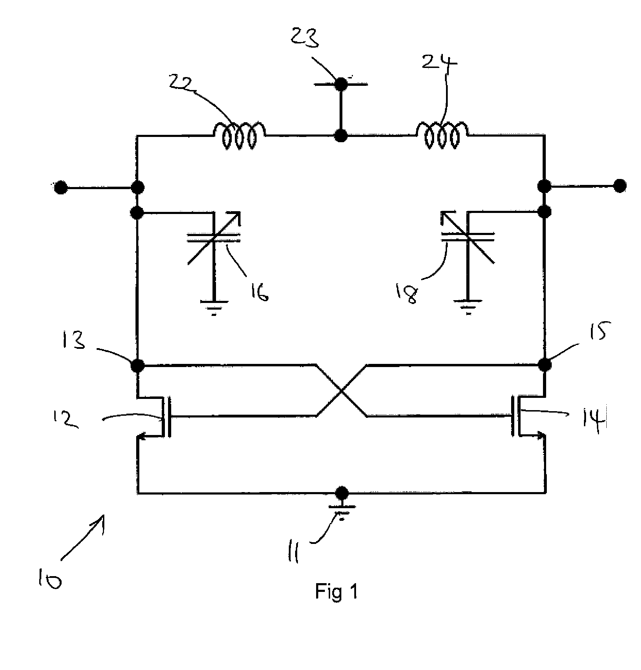

Figure 1 shows a well-known differential oscillator circuit (10) having a first and a second NMOS transistor (12.14). Each transistor (12,14) has its source coupled to earth reference (11) and its gate cross-coupled to the drain of the respective other transistor. The drain (13) of the first transistor (12) is connected via a first serial inductance (22) to a positive supply node (23). The drain (15) of the second transistor (14) is coupled via a second serial inductance (24) to the positive supply node. The drain (13) of the first transistor (12) is coupled to earth via a first variable capacitor (16), and the drain of the second transistor (14) is coupled to earth via a second variable capacitor (18).

As is well known to those skilled in the art, the frequency of oscillation is determined by the resonance of the tank circuit formed by the first and second variable capacitors (16,18) and inductances (22,24). If the inductances are equal, and have a value of L1 and the capacitances the same as one another and have a value of C1, then

$$Fo \approx 1 / (2\,\pi)^* \; [L1 * C1]1/2$$

Hence by choosing the value of C1 the frequency may be selected. By varying it, the frequency is varied.

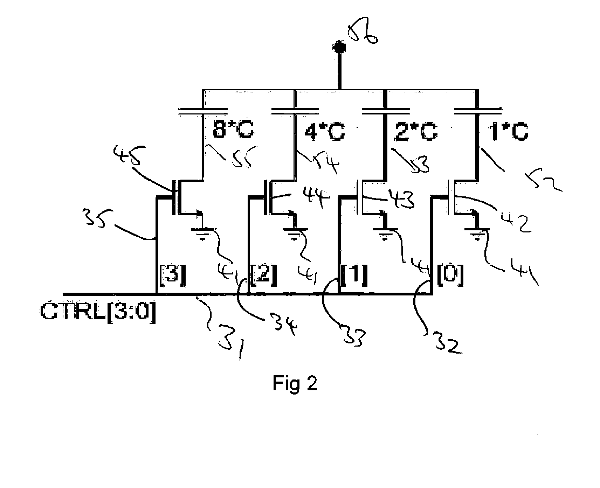

Fig 2 shows a part of an integrated circuit used for selecting capacitance by digital selection. Referring to Fig 2, a 4-bit bus (31) has its respective bit lines (32-35) coupled the gates of respective NMOSTs (42-45). The sources of the NMOSTs (42-45) are connected to an earth reference node (41) and the drains connect via respective capacitors (52-55) to a common node (56). The first NMOST (42) is connected via a first of the capacitors (52), having a value of C2, to the common node (56); the second NMOST(43) is connected via a second of the capacitors (53), having a value of 2* C2, to the common node (56); the third NMOST(43) is connected via a first of the capacitors (54), having a value of 4*C2, to the common node (56); the fourth NMOST(45) is connected via a first of the capacitors (55), having a value of 8*C2, to the common node (56)..

In use, the common node (56) is connected for example, to the oscillator of Fig 1, and to the drain (14) in place of the capacitor (16). A like-circuit is connected in place of the second capacitor (18). In this case, the range of capacitance of each capacitor-selecting circuit is from C2 to 15* C2 , so the frequency of the oscillator may be varied between Fo ≈ 1 / (2 π)* [(L1 * C2)]1/2 and Fo ≈ 1 / (2 π))* [15(L1 * C2)]1/2

Variation is achieved using the bus (31). When only the first MOST (42) is controlled from the bus to be on, the capacitance between common node (56) and earth (41) has value C2. When only the second MOST (42) is turned on, the capacitance between common node (56) and earth (41) has value 2*C2 and so on. By rendering two or more MOSTs in the "on" state, intervening capacitance levels may be achieved. For example, for 3*C2 both first and second MOSTs (42,43) are "on".

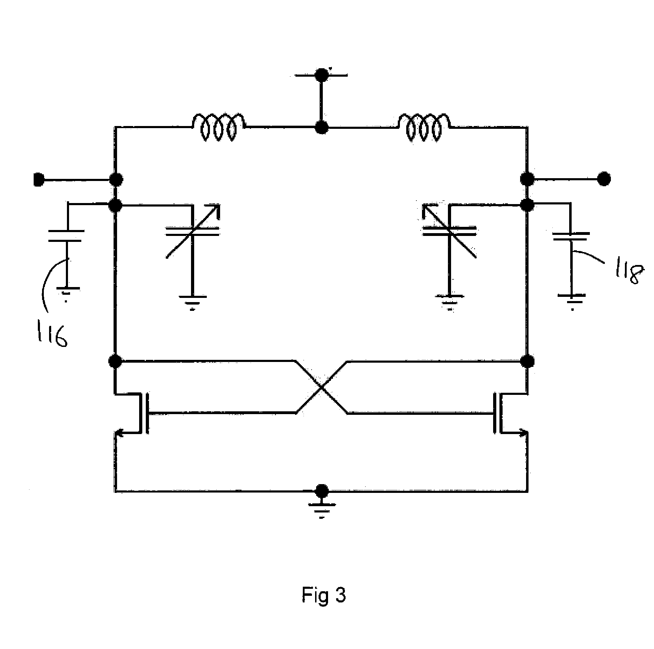

In one oscillator, the circuit of Fig 2 is coupled in parallel to a fixed capacitor that determines the maximum operating frequency of the oscillator. This arrangement is shown in Fig. 3, with fixed capacitors (116, 118) parallel to the variable capacitor circuits (16,18), each embodied as a circuit as shown in Fig. 2. Then the circuit of Fig. 2 is used to fine-tune the output frequency by selectively increasing the capacitance to reduce the resonant frequency of the tank to a desired operating frequency.

In some oscillators, for example voltage controlled oscillators used in RF communications systems, fine resolution of frequency is essential. To achieve this using switched capacitors is hard. The smallest capacitor used in the switched capacitor array limits the resolution of the VCO frequency steps. And these steps must be smaller than the voltage tuning range to ensure constant frequency coverage.

Achieving a very small and well controlled capacitance is difficult. In some applications a tiny unit capacitance of less than 5fF is required.

The traditional approach to achieve tiny capacitors is to couple two or more, typically several, larger capacitors in series. However, this has some serious disadvantages since a number of larger capacitors occupies real estate on the chip, while at the same time creating problems due to parasitic effects (R, L & C).

In all integrated circuit technologies there is a practical limit to the smallest sized, well-controlled capacitor realisable, whichever device type is chosen. The limit is generally caused by two factors;

   1) Minimum allowed capacitor device structure geometry according to process design rules
   2) Parasitics R, L & C associated with including a transistor switch in series with the capacitor.

To illustrate the geometry limit, a typical 65nm CMOS process may have a Metal-Insulator-Metal (MIM) type capacitor with a minimum physical size limit of $4\,\mu$m x $4\,\mu$m, with a 2fF/$\mu$m-2 - 2 femtofarads per square micron- capacitance density, giving a 32fF minimum unit capacitor. This is large when compared to possible required vales of less than 5fF.

As noted above, the minimum device size problem is often addressed by using plural capacitors in series. For example eight 32fF capacitors in series would have a capacitance of 4fF. Using this configuration the total capacitance can be adjusted to any arbitrary small value, but at the cost of large silicon area and high parasitic capacitance (C), resistance (R) and inductance (L). For very small capacitance values, this approach becomes impossible to use in practice, as the parasitics involved quickly dominate the desired capacitance values, and the silicon area used may be unacceptable.

In one aspect there is disclosed an integrated circuit device having an LC tank circuit for frequency setting, and a switched capacitor circuit for tuning the resonant frequency of the LC tank, **characterised in that** the switched capacitor circuit has plural sets of parallel branches, each set comprising a first branch and a second branch, the first and second branches each connecting between a first node and a second node, each branch containing a respective capacitor in series with a switch, the switched capacitor circuit being configured such that, in use, the switch of the first branch is on when the switch of the second branch is off and vice versa.

The integrated circuit device is, in an embodiment, a differential oscillator.
In another embodiment it is a single-ended oscillator. In yet another embodiment it is an LC filter.

In a further aspect there is disclosed an integrated circuit device having an RC circuit, and a switched capacitor circuit for controlling the time constant of the RC circuit, **characterised in that** the switched capacitor circuit has plural sets of parallel branches, each set comprising a first branch and a second branch, the first and second branches each connecting between a first node and a second node, each branch containing a respective capacitor in series with a switch, the switched capacitor circuit being configured such that, in use, the switch of the first branch is on when the switch of the second branch is off and vice versa.

Each set may comprise a pair of branches, and in each pair the capacitor of the second branch may have a capacitance that differs from that of the capacitor of the first branch by an amount defined as a step size, and in one pair the step size is less than the other step sizes.

In that one pair the step size may be a capacitance equal to or less than the capacitance of a capacitor having the minimum feature size of the process by which the integrated circuit was formed.

The capacitor of each first branch may have identical capacitance.

In each set the second branch capacitor may have a capacitance that differs from that of the first branch capacitor by an amount defined as a step size, wherein the step size of each stage is different.

In each set the second branch capacitor may have a capacitance that differs from that of the first branch capacitor by an amount defined as a step size, and in one set the step size be less than the other step sizes. Then the step size of each remaining set may be a multiple of two times that step size.

There is also disclosed a method of tuning the resonant frequency of an integrated LC tank circuit for frequency determination, the method adjusting a capacitance of the LC tank by selecting a respective first or a respective second branch in each of plural pairs of parallel branches.

In such a method, each pair of parallel branches may consist of a first branch with a first capacitor and a respective second branch with a second capacitor, the arrangement being that selecting a respective branch connects the respective capacitor in circuit.

In each pair of parallel branches, the respective second capacitor may have a capacitance that differs from that of the first capacitor by an amount defined as a step size, and in one stage the step size is less than the other step sizes.

In one embodiment, all of the first capacitors have the same first capacitance

In one embodiment, the second capacitors have mutually different values of capacitance.

Brief description of drawings

In the drawings:

> Fig 1 shows a partial schematic diagram of an exemplary integrated FET oscillator;
> Fig 2 shows a partial schematic drawing of a switched capacitor circuit usable with the oscillator of Fig 1;
> Fig 3 shows a partial schematic diagram of a second exemplary integrated FET oscillator;
> Fig 4 shows an embodiment of an integrated switched capacitor circuit of an oscillator circuit.

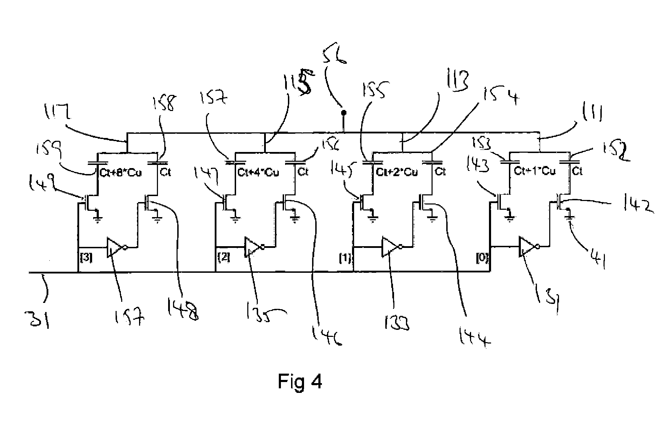

Referring to Fig. 4, this shows a part of an oscillator circuit integrated using a conventional integration process.
The single capacitors of Fig 2 are each replaced by a respective pair of parallel branches (111,113,115,117). In this embodiment four such branches are used, specifically first branch (111), second branch (113), third branch (115) and fourth branch (117). The branches connect between the common node (56) and the earth reference node (41).

Each branch (111,113,115,117) has a respective pair of NMOS transistors (142,143;144,145;146,147; 148,149), consisting of first transistors (142,144,146,148) and second transistor (143,145,147,149). Each branch also has a respective first capacitor (152,154,156,158) and a respective second capacitor (153,155, 157, 159)

The drain of each first transistor (142,144,146,148) is connected to the common node (56) via a respective first capacitor (152,154,156,158). The drain of each second transistor (143,145,147,149) is connected to the common node (56) via a respective second capacitor (153,155, 157, 159).

The gate of each first transistor (142,144,146,148) is connected to a respective conductor of the bus (31) via a respective inverter (131,133,135,137), and the gate of each second transistor (143,145,147,149) is connected to the like conductor of the bus (31) directly, ie without inversion.

In this embodiment all of the first capacitors (152,154,156,158) are of the same capacitance Ct. The second capacitor (153) of the first branch (111) has a value of Cs+ Ct, where Cu is herein referred to as minimum step size and has a value smaller than the capacitance of the minimum capacitor size capable of being made using the fabrication process of the integrated circuit.

In the second branch, the second capacitor (155) has a value of [2* Cu]+ Ct ; in the third the second capacitor (157) has a value of [4* Cu]+ Ct; in the third the second capacitor (159) has a value of [8* Cu]+ Ct.

In operation, when the bus (31) has all four lines at logic 0, all the four first transistors (142,144,146,148) will be "on" and all the second transistors (143,145,147,149) will be "off". Thus the capacitance between the common node (56) and ground will be [4* Ct].

If only the first branch is activated by turning on its second transistor (143), the first transistor (142) turns off due to the inverter (131) and the capacitance between the common node (56) and ground will be [4* Ct] + Cu

If only the second branch is activated by turning on its second transistor (145), the first transistor (144) turns off due to the inverter (133) and the capacitance between the common node (56) and ground will be [4* Ct] + [2*Cu]

It will be seen therefore that whatever the bus state, the capacitance between the common node (56) and ground (41) will lie between [4* Ct] and [4* Ct] + [15* Cu].

This is a convenient embodiment, however the invention is not restricted to the details of the embodiment.

The proposed invention achieves an arbitrarily small LSB capacitor size, with lower area usage than using series combined capacitors, and does not have the draw back of excessive parasitic capacitance, resistance or inductance.

This technique is specifically suited where monotonicity of programmable C is needed, rather than bit-linearity, for example in calibrating a tuned LC element.

The described embodiment is a differential circuit, but the invention is not restricted to this and extends to single-ended oscillator circuits as well. Oscillators may be voltage-controlled.

Other embodiments include LC filters, RC filters and such other applications where fine control of capacitance is required in integrated circuit devices as would be known to the person of ordinary skill in the art..

**Claims**

1. An integrated circuit device having an LC tank circuit for frequency determination, and a switched capacitor circuit for tuning the resonant frequency of the LC tank, **characterised in that** the switched capacitor circuit has plural sets of parallel branches, each set comprising a first branch and a second branch, the first and second branches each connecting between a first node and a second node, each branch containing a respective capacitor in series with a switch, the switched capacitor circuit being configured such that, in use, the switch of the first branch is on when the switch of the second branch is off and vice versa.

2. An integrated circuit device according to claim 1, the device being one of a group comprising an oscillator and an LC filter.

3. An integrated circuit device having an RC circuit, and a switched capacitor circuit for controlling the time constant of the RC circuit, **characterised in that** the switched capacitor circuit has plural sets of parallel branches, each set comprising a first branch and a second branch, the first and second branches each connecting between a first node and a second node, each branch containing a respective capacitor in series with a switch, the switched capacitor circuit being configured such that, in use, the switch of the first branch is on when the switch of the second branch is off and vice versa.

4. An integrated circuit device according to claim 1, 2 or 3, wherein each set comprises a pair of branches, and in each pair the capacitor of the second branch has a capacitance that differs from that of the capacitor of the first branch by an amount defined as a step size, and in one pair the step size is less than the other step sizes.

5. An integrated circuit device according to claim 4, wherein in said one pair the step size is a capacitance equal to or less than the capacitance of a capacitor having the minimum feature size of the process by which the integrated circuit was formed.

6. An integrated circuit device according to any preceding claim, wherein the capacitor of each first branch has identical capacitance.

7. An integrated circuit device according to claim 1, 2 or 3 wherein in each set the second branch capacitor has a capacitance that differs from that of the first branch capacitor by an amount defined as a step size, wherein the step size of each stage is different

8. An integrated circuit device according to claim 1, 2 or 3, wherein in each set the second branch capacitor has a capacitance that differs from that of the first branch capacitor by an amount defined as a step size, and in one set the step size is less than the other step sizes, and wherein the step size of each remaining set is a multiple of two times the step size less than the other step sizes

9. A method of tuning the resonant frequency of an integrated LC tank circuit for frequency determination, the method adjusting a capacitance of the LC tank by selecting a respective first or a respective second branch in each of plural pairs of parallel branches.

10. A method of controlling the time constant of an integrated RC circuit, the method adjusting a capacitance of the RC circuit by selecting a respective first or a respective second branch in each of plural pairs of parallel branches

11. A method according to claim 9 or 10, wherein each pair of parallel branches comprises a first branch with a first capacitor and a respective second branch with a second capacitor, the arrangement being that selecting a respective branch connects the respective capacitor in circuit.

12. A method according to claim 9, 10 or 11, wherein in pair of parallel branches, the respective second capacitor has a capacitance that differs from that of the first capacitor by an amount defined as a step size, and in one stage the step size is less than the other step sizes.

13. A method according to claim 9, 10 or 11, wherein all of the first capacitors have the same first capacitance.

14. A method according to claim 9,10 or 11, the second capacitors have mutually different values of capacitance.

Fig 1

Fig 2

Fig 3

Fig 4

Europäisches
Patentamt

European
Patent Office

Office européen
des brevets

**EUROPEAN SEARCH REPORT**

Application Number

EP 12 18 0373

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | US 2006/255865 A1 (LI LARRY [US]) 16 November 2006 (2006-11-16) * paragraph [0040] * ----- | 1,2,4-9, 11-14 | INV. H03J3/20 |
| Y | US 7 248 124 B2 (MCCORQUODALE MICHAEL S [US] ET AL MCCORQUODALE MICHAEL SHANNON [US] ET) 24 July 2007 (2007-07-24) * column 25, line 6 - column 26, line 14; figures 9,20 * ----- | 1-14 | |
| Y | JP 61 166177 A (MITSUBISHI ELECTRIC CORP) 26 July 1986 (1986-07-26) * the whole document * ----- | 3,10 | |
| A | EP 2 458 681 A1 (HITACHI METALS LTD [JP]) 30 May 2012 (2012-05-30) * paragraph [0086]; figure 10 * ----- | 1-14 | |

TECHNICAL FIELDS
SEARCHED (IPC)

H03B
H03J

The present search report has been drawn up for all claims

| Place of search | Date of completion of the search | Examiner |
|---|---|---|
| The Hague | 5 December 2012 | Peeters, Mark |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

..............................................................................
& : member of the same patent family, corresponding
    document

EPO FORM 1503 03.82 (P04C01)

EP 2 698 919 A1

**ANNEX TO THE EUROPEAN SEARCH REPORT
ON EUROPEAN PATENT APPLICATION NO.**                EP 12 18 0373

This annex lists the patent family members relating to the patent documents cited in the above-mentioned European search report.
The members are as contained in the European Patent Office EDP file on
The European Patent Office is in no way liable for these particulars which are merely given for the purpose of information.

05-12-2012

| Patent document cited in search report | | Publication date | Patent family member(s) | Publication date |
|---|---|---|---|---|
| US 2006255865 | A1 | 16-11-2006 | NONE | |
| US 7248124 | B2 | 24-07-2007 | NONE | |
| JP 61166177 | A | 26-07-1986 | NONE | |
| EP 2458681 | A1 | 30-05-2012 | CN 102696149 A | 26-09-2012 |
| | | | EP 2458681 A1 | 30-05-2012 |
| | | | KR 20120092663 A | 21-08-2012 |
| | | | US 2012146865 A1 | 14-06-2012 |
| | | | WO 2011059088 A1 | 19-05-2011 |

For more details about this annex : see Official Journal of the European Patent Office, No. 12/82